# EUROPEAN PATENT APPLICATION

(11) **EP 4 813 957 A1**
(43) Date of publication of application: **30.09.2026**
(21) Application number: 24894119.7
(22) Date of filing: 18.11.2024
(51) Int. Cl.: C04B 35/587, C04B 37/02, H01L 23/13, H05K 1/03

(54) **CERAMIC SUBSTRATE AND CERAMIC CIRCUIT BOARD USING SAME**

(30) Priority: 20.11.2023 JP 2023196865
(71) Applicant: Niterra Materials Co., Ltd., Kanagawa 235-0032 (JP)
(72) Inventor: TAKEUCHI, Yuta, Yokohama-shi, Kanagawa 235-0032 (JP); AOKI, Katsuyuki, Yokohama-shi, Kanagawa 235-0032 (JP); YAMAGATA, Yoshihito, Yokohama-shi, Kanagawa 235-0032 (JP); IWAI, Kentaro, Yokohama-shi, Kanagawa 235-0032 (JP)
(74) Representative: Hoffmann Eitle
(86) International application number: PCT/JP2024/040855
(87) International publication number: WO 2025/110128

(57) **Abstract**

A ceramic substrate according to an embodiment of the present invention has compressive stress of different values in a first direction and a second direction parallel to the surface and orthogonal to each other. When the compressive stress in the first direction is defined as compressive stress A and the compressive stress in the second direction is defined as compressive stress B, 4/6 ≤ compressive stress A/compressive stress B ≤ 6/4 is satisfied.

## Description

### [Technical Field]

Embodiments described herein relate generally to a ceramic substrate and a ceramic circuit board using the same.

### [Background Art]

Ceramic substrates are used in ceramic circuit boards on which semiconductor elements are mounted. Ceramic substrates are, for example, silicon nitride substrates, aluminum nitride substrates, aluminum oxide substrates, and zirconium oxide substrates.

For example, Japanese Patent No. 6293772 (Patent Literature 1) discloses a silicon nitride substrate having a thermal conductivity of 50 W/m·K or more and a three-point bending strength of 600 MPa or more. The silicon nitride substrate of Patent Literature 1 has excellent insulation even if the substrate thickness is decreased. Further, even in a case where this silicon nitride substrate is used as a silicon nitride circuit board by bonding a metal plate thereto, excellent insulation can be obtained.

Meanwhile, there have been variations in temperature cycle test (TCT) characteristics. For example, Japanese Patent No. 6789955 (Patent Literature 2) discloses a technique of controlling the size and hardness of a bonding layer protruding portion. Performing the control as described in Patent Literature 2 can improve TCT characteristics. However, TCT characteristics of some products have been insufficient. Investigation of the cause has revealed that the residual stress in the ceramic substrate has caused the insufficiency. For example, International Publication No. WO2014/080536 (Patent Literature 3) discloses an aluminum nitride substrate having a surface residual stress of -60 MPa or less.

### [Prior Art Documents]

### [Patent Literature]

[Patent Literature 1] Japanese Patent No. 6293772
[Patent Literature 2] Japanese Patent No. 6789955
[Patent Literature 3] International Publication No. WO2014/080536

### [Summary of Invention]

### [Problem to be Solved by the Invention]

In Patent Literature 3, the residual stress on the surface of the aluminum nitride substrate is controlled to -60 MPa or less. The negative residual stress indicates compressive stress. In Patent Literature 3, the compressive stress is controlled to thereby improve the TCT characteristics of the aluminum nitride circuit board.

As shown in Patent Literature 2, the recent trend is to increase the thickness of a metal plate in a ceramic circuit board to 0.6 mm or more. When the metal plate is made thicker, TCT is not always improved only by controlling the residual stress to a predetermined value or less.

To address such problems, embodiments described herein provide a ceramic substrate in which residual stress is appropriately controlled.

### [Means for Solving the Problem]

A ceramic substrate according to an embodiment includes a surface, and has a compressive stress in a first direction and a compressive stress in a second direction, the compressive stress in the first direction and the compressive stress in the second direction having different values, the first direction and the second direction being parallel to the surface and orthogonal to each other. The ceramic substrate satisfies 4/6 ≤ compressive stress A/compressive stress B ≤ 6/4 where the compressive stress A denotes the compressive stress in the first direction and the compressive stress B denotes the compressive stress in the second direction.

### [Brief Description of Drawings]

[FIG. 1] FIG. 1 is a perspective view of an example of a ceramic substrate according to an embodiment.
[FIG. 2] FIG. 2 is a plan view showing example measurement positions upon X-ray residual stress measurement.
[FIG. 3] FIG. 3 is a side view of an example of a ceramic circuit board according to the embodiment.
[FIG. 4] FIG. 4A and FIG. 4B are plan views of examples of the ceramic circuit board according to the embodiment.
[FIG. 5] FIG. 5A and FIG. 5B are side views showing example dry blasting.
[FIG. 6] FIG. 6 is a flowchart showing processes for manufacturing the ceramic substrate according to the embodiment.

### [Description of Embodiments]

A ceramic substrate according to an embodiment includes a surface, and has a compressive stress in a first direction and a compressive stress in a second direction, the compressive stress in the first direction and the compressive stress in the second direction having different values, the first direction and the second direction being parallel to the surface and orthogonal to each other. The ceramic substrate satisfies 4/6 ≤ compressive stress A/compressive stress B ≤ 6/4 where the compressive stress A denotes the compressive stress in the first direction and the compressive stress B denotes the compressive stress in the second direction.

The ceramic substrate according to the embodiment may have any of various shapes including a quadrangular shape, a circular shape (including an elliptic shape), a triangular shape, a pentagonal shape, a hexagonal shape, an L-shape, and a U-shape. The quadrangular shape may be any of a square shape or a rectangular shape. The shape of the ceramic substrate is a shape when a face on which a circuit portion is provided is viewed from above.

The first direction and the second direction are any directions parallel to the surface. For example, in a case where the ceramic substrate has a quadrangular shape, the first direction may be parallel to the long-side direction and the second direction may be parallel to the short-side direction. In a case where the first direction is oblique to the long-side direction, the second direction is a direction orthogonal to the oblique direction.

Compressive stress is stress generated in an object when an external force is applied in a direction of compressing the object. Stress opposite to compressive stress is tensile stress. Tensile stress is stress generated in an object when an external force is applied in a direction of stretching the object. Compressive stress is indicated by a negative value. Tensile stress is indicated by a positive value.

Hereinafter, embodiments of the invention will be described while taking a quadrangular (rectangular) ceramic substrate as an example.

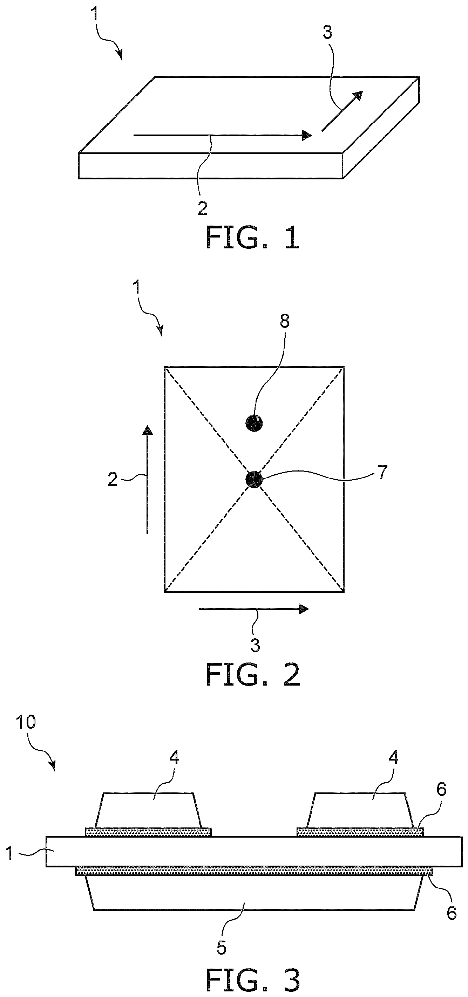

FIG. 1 is a perspective view of an example of a ceramic substrate according to an embodiment. In FIG. 1, reference numeral 1 indicates a ceramic substrate, reference numeral 2 indicates a direction parallel to the long side (long-side direction), and reference numeral 3 indicates a direction parallel to the short side (short-side direction).

The compressive stress in the first direction and that in the second direction have different values, and the compressive stress in the first direction is denoted by compressive stress A and the compressive stress parallel to the other side is denoted by compressive stress B. FIG. 1 illustrates a rectangular ceramic substrate. For example, the first direction is parallel to one of the long-side direction or the short-side direction. The second direction is parallel to the other of the long-side direction or the short-side direction. The compressive stress A and the compressive stress B are compressive stresses in two directions orthogonal to each other and parallel to the respective sides. In a case where the compressive stress in the long-side direction is defined as "compressive stress A", the compressive stress in the short-side direction is defined as "compressive stress B". Conversely, in a case where the compressive stress in the short-side direction is defined as "compressive stress A", the compressive stress in the long-side direction is defined as "compressive stress B".

In the following examples, the first direction is parallel to the long-side direction, and the compressive stress in the first direction is referred to as "compressive stress A". The second direction is parallel to the short-side direction, and the compressive stress in the second direction is referred to as "compressive stress B".

The ceramic substrate according to the embodiment has compressive stresses having different values in the first direction and the second direction. This means that the compressive stress A and the compressive stress B are different. The ceramic substrate according to the embodiment satisfies 4/6 ≤ compressive stress A/compressive stress B ≤ 6/4. The compressive stress A and the compressive stress B are preferably within a range of not less than -250 MPa and not more than -60 MPa. Hereinafter, the ratio of "compressive stress A/compressive stress B" is also simply referred to as "ratio A/B".

Regarding the ratio A/B, the ratio A/B = 1 is excluded because the compressive stress A and the compressive stress B are different from each other. The ratio A/B = 1 means that the ratio A/B is within a range of not less than 0.995 and not more than 1.004. Further, the ratio A/B within a range of not less than 4/6 and not more than 6/4 indicates that the ratio A/B is not less than 0.667 and not more than 1.500. That is, the ratio A/B within a range of not less than 4/6 and not more than 6/4 and the ratio A/B ≠ 1 indicates that the ratio A/B is within a range of not less than 0.667 and not more than 1.500 and outside a range of not less than 0.995 and not more than 1.004.

Since the ratio A/B is within the range described above, TCT characteristics when the ceramic substrate is used in a ceramic circuit board can be improved. As will be described below, in the ceramic circuit board, a circuit portion is bonded to the ceramic substrate. When the circuit portion repeatedly expands and contracts in a TCT, the occurrence of faults can be suppressed as long as the compressive stress of the ceramic substrate is controlled.

The faults are the occurrence of defects, such as cracks in the ceramic substrate and cracks in the bonding layer. When the circuit portion expands, tensile stress is generated in the ceramic substrate and the bonding layer. When the circuit portion contracts, compressive stress is generated in the ceramic substrate and the bonding layer. In particular, when the circuit portion expands, that is, when tensile stress is generated, cracking is likely to occur. When a predetermined compressive stress is applied in advance to the surface of the ceramic substrate, the effect of tensile stress associated with expansion of the circuit portion can be mitigated.

Further, as the size of the circuit portion increases, the amount of deformation of the circuit portion caused by heat increases. When the direction in which the dimension of the circuit portion is long is aligned with the direction in which the compressive stress is large, the effect of tensile stress associated with expansion of the circuit portion can be further mitigated.

The compressive stress A and the compressive stress B are preferably within a range of not less than -250 MPa and not more than -60 MPa. That is, both the compressive stress in the long-side direction and the compressive stress in the short-side direction are within a range of not less than -250 MPa and not more than -60 MPa. If the compressive stress A and the compressive stress B are smaller than -60 MPa, there is a possibility that the effect of reducing the tensile stress associated with expansion of the circuit portion is insufficient. Further, if the compressive stress A and the compressive stress B are larger than -250 MPa, there is a possibility that cracking occurs by a synergistic effect with the compressive stress generated when the circuit portion contracts. Therefore, the compressive stress A and the compressive stress B are preferably within a range of not less than -250 MPa and not more than -60 MPa, and more preferably within a range of not less than -200 MPa and not more than -80 MPa. A large compressive stress is indicated by a large negative value. A small compressive stress is indicated by a small negative value. For example, in a case where a stress of - 250 MPa is compared with a stress of -60 MPa, a stress of -250 MPa is a larger compressive stress.

Further, when the ratio A/B ≠ 1 and 4/6 ≤ ratio A/B ≤ 6/4 are satisfied, the effect of tensile stress associated with expansion of the circuit portion and the effect of compressive stress associated with contraction of the circuit portion can be mitigated. The circuit portion varies in shape. In the circuit portion, tensile stress associated with expansion and compressive stress associated with contraction are generated in accordance with the shape of the circuit portion. When the above conditions are satisfied, stresses generated in various directions can be reduced.

A stress that differs depending on the direction is applied to the ceramic substrate 1 in accordance with the shape of the circuit portion. If the ratio A/B = 1 is satisfied, that is, the compressive stress A and the compressive stress B are the same, the stress that differs depending on the direction is unable to be effectively reduced. If the ratio A/B is smaller than 4/6 or larger than 6/4, the difference between the compressive stresses in the first direction and the second direction is excessively large, and there is a possibility that the effect of stress reduction in a specific direction is insufficient.

The circuit portion varies in shape. Therefore, if the ratio A/B is not less than 4/6 and not more than 6/4, the effect of stress reduction corresponding to the shape of the circuit portion can be obtained. As a ceramic substrate on which semiconductor elements are mounted, a quadrangular ceramic substrate is often used. The circuit portion is often provided along the sides of the quadrangular ceramic substrate. Therefore, it is preferable to control the ratio between the compressive stress A in the long-side direction of the ceramic substrate and the compressive stress B in the short-side direction thereof.

For example, when the circuit portion bonded to the ceramic substrate 1 expands or contracts, stress is applied from the circuit portion to the ceramic substrate 1. In a case where the circuit portion has a rectangular shape in plan view, the amount of thermal expansion of the circuit portion in the longitudinal direction is larger than the amount of thermal expansion of the circuit portion in the lateral direction. Therefore, when the circuit portion expands, a tensile stress applied to the ceramic substrate 1 in the longitudinal direction is larger than a tensile stress applied to the ceramic substrate 1 in the lateral direction. When the circuit portion contracts, a compressive stress applied to the ceramic substrate 1 in the lateral direction is larger than a compressive stress applied to the ceramic substrate 1 in the longitudinal direction.

In a case where the circuit portion is bonded to the ceramic substrate 1 according to the embodiment, it is effective to align the longitudinal direction of the circuit portion with a direction in which the compressive stress of the ceramic substrate 1 is large. For example, in a case where the size and orientation of a circuit portion to be bonded to the ceramic substrate 1 are known in advance, compressive stresses are applied to the surface of the ceramic substrate 1 in the first direction and the second direction respectively, in accordance with the size and orientation of the circuit portion.

As described above, it is effective to control compressive stresses of the ceramic substrate 1 in accordance with the shape of the circuit portion. In other words, the embodiment is suitable for a ceramic substrate on which a circuit portion having different lengths in the first direction and the second direction is mounted.

In the embodiment, it is preferable to satisfy 4/6 ≤ ratio B/A ≤ 6/4. That is, the magnitude relationship between the compressive stress A in the first direction and the compressive stress B in the second direction can be set as desired. Further, the first direction and the second direction can also be set as desired. Even if the magnitude relationship between the compressive stress A in the first direction and the compressive stress B in the second direction changes, the effect of stress reduction can be improved by setting the ratio A/B and the ratio B/A within a range of not less than 4/6 and not more than 6/4.

Control of compressive stress on the ceramic substrate 1 is performed on a face to which the circuit portion or a heat dissipation portion is bonded. In a case where the circuit portion and the heat dissipation portion are respectively bonded to both faces of the ceramic substrate 1, compressive stresses of both faces are controlled. In a case where the circuit portion is bonded to only one of the faces of the ceramic substrate 1, compressive stress is controlled only on the face to which the circuit portion is bonded.

A method for measuring residual stress will be described. Residual stress is measured by a single exposure method using an X-ray residual stress measuring device. As the X-ray residual stress measuring device, µX360s from Pulstec Industrial Co., Ltd. or a device having performance equivalent thereto is used. In a case where the ceramic substrate 1 is a silicon nitride substrate, measurement conditions of a vanadium target (V - Kα), an incident angle of 30°, and a sample measurement distance of 45 mm are set. Compressive stress is measured using the (411) diffraction peak.

FIG. 2 is a plan view showing example measurement positions upon X-ray residual stress measurement. Residual stress is measured at two locations on the surface of the ceramic substrate 1. In FIG. 2, reference numeral 1 indicates the ceramic substrate, reference numeral 7 indicates a first measurement point, and reference numeral 8 indicates a second measurement point. The first measurement point 7 is located at the center of the ceramic substrate 1. The center of the ceramic substrate 1 is a point at which straight lines each connecting opposite corners intersect with each other. The second measurement point 8 is the midpoint between the first measurement point 7 and any of the short sides.

First, residual stresses on the surface in the first direction and the second direction are measured at one of the first measurement point 7 or the second measurement point 8. Next, residual stresses on the surface in the first direction and the second direction are measured at the other of the first measurement point 7 or the second measurement point 8. For the ceramic substrate 1 according to the embodiment, compressive stresses are measured. The average of the compressive stress at the first measurement point 7 in the first direction and the compressive stress at the second measurement point 8 in the first direction is assumed to be the compressive stress of the ceramic substrate 1 in the first direction. The average of the compressive stress at the first measurement point 7 in the second direction and the compressive stress at the second measurement point 8 in the second direction is assumed to be the compressive stress of the ceramic substrate 1 in the second direction. The cosα method is used in calculation of the compressive stresses.

In a case of an aluminum oxide substrate, measurement conditions of an iron target (Fe - Kα), an incident angle of 30°, and a sample measurement distance of 45 mm are set. Compressive stress is measured using the (2.1.10) diffraction peak.

In a case of an aluminum nitride substrate, measurement conditions of a chromium target (Cr - Kα), an incident angle of 30°, and a sample measurement distance of 45 mm are set. Compressive stress is measured using the (112) diffraction peak.

The X-ray target and the diffraction peak are selected in accordance with the material of the ceramic substrate. For the selection, see a method recommended by the Ceramics Subcommittee of the X-ray Material Strength Section Committee of The Society of Materials Science, Japan (for example, Ceramics section in JSMS-SD-1-00 X-ray Stress Measurement Standard).

For the ceramic substrate according to the embodiment, the compressive stress in a direction parallel to the long side or a direction parallel to the short side is preferably within a range of not less than -250 MPa and not more than -60 MPa, regardless of which portion of the surface is measured.

The maximum height Sz on the surface of the ceramic substrate is preferably 60 µm or less. The maximum height Sz is the distance between the highest point (the highest projection) and the lowest point (the lowest indentation) on the surface. The distance is measured in the thickness direction of the ceramic substrate 1. The maximum height Sz is defined in ISO 25178 and is measured by a method conforming to ISO 25178. As the measuring device, the one-shot 3D form measuring machine VR-5000 series from KEYENCE or a device having performance equivalent thereto is used. The measurement range is set to 9 mm in length and 12 mm in width. In a case where any area of 9 mm by 12 mm on the surface is measured, the ceramic substrate 1 according to the embodiment preferably has a maximum height Sz of 60 µm or less.

If the maximum height Sz is 60 µm or less, the compressive stress can be easily controlled to within a predetermined range. Further, the bondability between the ceramic substrate 1 and the metal plate can be improved. The lower limit of the maximum height Sz is not specifically limited, but is preferably 30 µm or more. As will be described below, the compressive stress is controlled by using, for example, blasting. In a case where blasting is used, controlling the maximum height Sz within a predetermined range is effective in controlling the residual stress. If the maximum height Sz exceeds 60 µm, there is a possibility that a portion in which the residual stress is smaller than -60 MPa is formed. If the maximum height Sz is less than 30 µm, the residual stress on the surface is homogenized, and the ratio A/B tends to decrease. As a result, there is a possibility that a portion having the ratio A/B = 1 is formed on the surface. Therefore, the maximum height Sz is preferably 60 µm or less, and more preferably within a range of not less than 30 µm and not more than 60 µm.

On the surface of the ceramic substrate 1, the difference between the maximum projection height and the maximum indentation depth of the waviness is preferably 1.6 mm or less. The waviness is gentle irregularities of the surface of the ceramic substrate. The waviness is distinguished from the maximum height Sz described above.

A method for measuring the maximum projection height and the maximum indentation depth of the waviness will be described. First, the ceramic substrate 1 is placed on a flat stage. Next, the height of the ceramic substrate 1 is measured with a laser. The measurement area is set at any position on the surface, and the size is set to 132 mm by 106 mm. A total of 143 measurement points of 13 points by 11 points are set in the measurement area, and the height is measured at each measurement point. The measurement points of 13 points by 11 points are set evenly without imbalance. The largest value among the measurement results is regarded as the maximum projection height, and the smallest value is regarded as the maximum indentation depth. In a case where the ceramic substrate 1 is smaller than 132 mm by 106 mm, a largest possible measurement area is set. Specifically, the ratio of the area of the set measurement area to the area of 132 mm by 106 mm is calculated. Measurement points as many as the number obtained by multiplying 143 by the ratio are set evenly in the set measurement area.

A difference between the maximum projection height and the maximum indentation depth of the waviness of the ceramic substrate 1 of 1.6 mm or less indicates (maximum projection height - maximum indentation depth) ≤ 1.6 mm. If the difference between the maximum projection height and the maximum indentation depth exceeds 1.6 mm, the waviness is too large, and this may make control of the ratio A/B difficult.

The lower limit of the difference between the maximum projection height and the maximum indentation depth of the waviness is not specifically limited, but is preferably 0.2 mm or more. Although the difference is ideally 0 mm, mirror polishing is required to make the difference between the maximum projection height and the maximum indentation depth be 0 mm. The mirror polishing causes an increase in costs. When the compressive stress is controlled, the effect of stress reduction can be obtained even if there is a difference between the maximum projection height and the maximum indentation depth of the waviness. Therefore, the difference between the maximum projection height and the maximum indentation depth of the waviness is preferably 1.6 mm or less, and more preferably within a range of not less than 0.2 mm and not more than 1 mm.

The ceramic substrate 1 is, for example, a silicon nitride substrate, an aluminum nitride substrate, an aluminum oxide substrate, or a zirconium oxide substrate. Ceramic substrates are classified according to a component contained the most. For example, silicon nitride substrates contain silicon nitride the most. Aluminum nitride substrates contain aluminum nitride the most. Ceramic substrates may contain a sintering aid component if necessary.

The thermal conductivity of silicon nitride substrates is 40 W/m·K or more, and can be 80 W/m·K or more. The three-point bending strength of silicon nitride substrates is 600 MPa or more, and can be 700 MPa or more.

The thermal conductivity of aluminum nitride substrates is 160 W/m·K or more, and can be 200 W/m·K or more. The three-point bending strength of aluminum nitride substrates is about 300 to 450 MPa. Although the three-point bending strength of aluminum oxide substrates is about 300 to 450 MPa, aluminum oxide substrates are less expensive than the other substrates. The thermal conductivity of aluminum oxide substrates is about 20 to 30 W/m·K. The three-point bending strength of zirconium oxide substrates is 500 MPa or more, and the thermal conductivity thereof is about 20 to 30 W/m·K.

The ceramic substrate 1 is preferably a silicon nitride substrate. Silicon nitride substrates have characteristics of both high strength and high thermal conductivity. Meanwhile, silicon nitride substrates are mainly composed of elongated silicon nitride crystal grains having an aspect ratio of 2 or more. Aluminum nitride crystal grains, aluminum oxide crystal grains, and zirconium oxide crystal grains are mainly round crystal grains having an aspect ratio of less than 2.

In silicon nitride substrates, elongated silicon nitride crystal grains are intricately entangled to attain high strength. Because of the structure of intricately entangled elongated silicon nitride crystal grains, the directions of compressive stresses have been random. This has caused variations in TCT characteristics. In the silicon nitride substrate according to the embodiment, since the compressive stress in each direction is controlled, TCT characteristics can be improved while high strength and high thermal conductivity are attained.

The thickness of the ceramic substrate 1 is preferably within a range of not less than 0.2 mm and not more than 3 mm. If the thickness is less than 0.2 mm, the insulation of the ceramic substrate 1 may be insufficient. If the thickness exceeds 3 mm, the insulation of the ceramic substrate 1 is excellent, but the heat dissipation thereof may be degraded.

Since silicon nitride substrates have high strength, the thickness of the substrate can be set within a range of not less than 0.2 mm and not more than 0.8 mm, and further within a range of not less than 0.2 mm and not more than 0.4 mm.

The length of the short side of the ceramic substrate 1 may be 100 mm or more. Even if the ceramic substrate 1 is a large-sized substrate having a short side of 100 mm or more, the characteristics can be improved by controlling the compressive stress. The length of the long side is not specifically limited, but is preferably 300 mm or less. If the length of the long side exceeds 300 mm, it may become difficult to control the difference between the maximum projection height and the maximum indentation depth of the waviness.

A large-sized substrate may be divided to perform multi-dicing. The multi-dicing is a method for obtaining a plurality of ceramic substrates by, for example, scribing a large-sized substrate and dividing the substrate. The multi-dicing may be performed on a bonded body in which a metal plate is bonded. In the ceramic substrate 1 according to the embodiment, the compressive stresses in any directions orthogonal to each other are controlled. In both the large-sized substrate and the plurality of ceramic substrates obtained after the division, the compressive stresses in any directions orthogonal to each other are controlled.

In the multi-dicing, a large-sized quadrangular substrate is divided. When the compressive stress A in the long-side direction of the large-sized substrate and the compressive stress B in the short-side direction thereof are controlled, the residual stresses of individual ceramic substrates obtained after the division can be controlled. According to the embodiment, a large-sized substrate suitable for the multi-dicing can be provided.

When a circuit portion is provided on the ceramic substrate according to the embodiment, a ceramic circuit board is obtained. FIG. 3 is a side view of an example of a ceramic circuit board according to the embodiment. In FIG. 3, reference numeral 1 indicates the ceramic substrate, reference numeral 4 indicates a metal plate (front metal plate), reference numeral 5 indicates a metal plate (back metal plate), reference numeral 6 indicates a bonding layer, and reference numeral 10 indicates a ceramic circuit board.

In the example shown in FIG. 3, the metal plate 4 and the metal plate 5 are bonded to the ceramic substrate 1 with the bonding layer 6 interposed. The metal plate 4 is used as a circuit portion, and the metal plate 5 is used as a heat sink. Two metal plates 4 are bonded to the ceramic substrate 1. The number of metal plates 4 is not limited to two, and a necessary number of metal plates 4 may be provided. The metal plates on both faces of the ceramic substrate 1 may be used as circuit portions. For convenience of explanation, the metal plate 4 may be herein referred to as a front metal plate and the metal plate 5 may be herein referred to as a back metal plate. Further, in the ceramic circuit board according to the embodiment, the circuit portion may be, for example, a metallized layer or a thin film instead of the metal plate.

The metal plate is, for example, a copper plate (including a copper alloy) or an aluminum plate (including an aluminum alloy). If necessary, the metal plate may be bonded to the ceramic substrate 1 with a bonding layer interposed therebetween. For example, the bonding layer is formed by an active metal bonding method using an active metal. In a case where a copper plate is bonded by the active metal bonding method, an active metal brazing filler containing an active metal, such as Ti, is used. In a case where an aluminum plate is bonded, an active metal brazing filler containing an active metal, such as Si, is used.

The metallized layer is formed by applying a metal paste onto the ceramic substrate 1 and firing the paste. The metallized layer contains, for example, one type selected from among Ag (silver), Cu (copper), Mo (molybdenum), and W (tungsten) as a main component. The thin film is conductive and is formed by sputtering or vapor deposition.

The circuit portion is preferably a metal plate. The thickness of the metal plate is, for example, 0.2 mm or more. The thickness of the metal plate is preferably 0.6 mm or more. When the metal plate is made thicker, the current carrying capacity and heat dissipation can be improved.

The circuit portion is formed of, for example, a metal plate, a metallized layer, or a thin film. When a TCT is performed, the metal plate generates the largest stress. In particular, in a case where a metal plate having a thickness of 0.6 mm or more is used, a larger stress is generated. Since compressive stress is controlled in the ceramic substrate 1 according to the embodiment, TCT characteristics are excellent even if a metal plate having a thickness of 0.6 mm or more is bonded.

The upper limit of the thickness of the metal plate is not specifically limited, but is preferably 5 mm or less. If the thickness of the metal plate exceeds 5 mm, it may be difficult to apply a pattern shape to the metal plate. Therefore, the thickness of the metal plate is preferably within a range of not less than 0.2 mm and not more than 5 mm, and more preferably within a range of not less than 0.6 mm and not more than 2 mm.

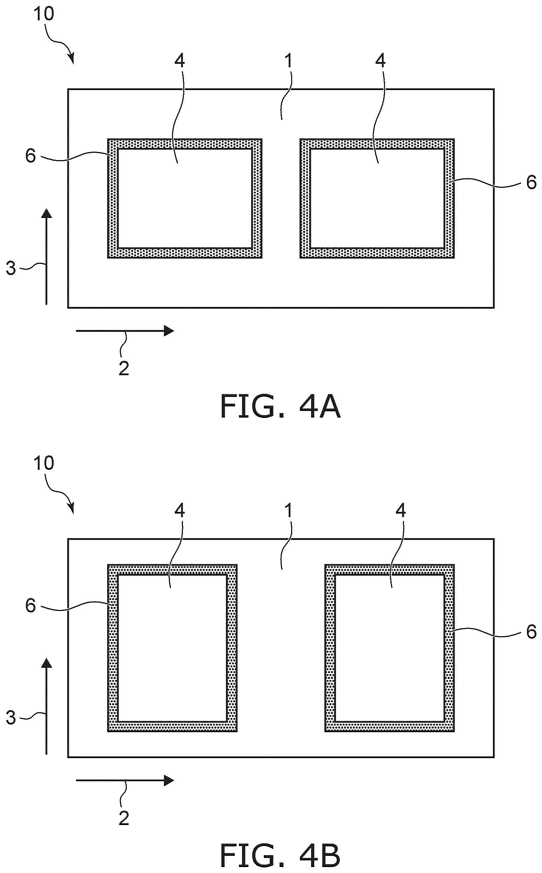

FIG. 4A and FIG. 4B are plan views of examples of the ceramic circuit board according to the embodiment. In FIG. 4A and FIG. 4B, reference numeral 1 indicates the ceramic substrate, reference numeral 2 indicates the long-side direction, reference numeral 3 indicates the short-side direction, reference numeral 4 indicates the metal plate (front metal plate), reference numeral 6 indicates the bonding layer, and reference numeral 10 indicates the ceramic circuit board.

In the example shown in FIG. 4A, the length of the metal plate 4 in the long-side direction 2 is longer than the length of the metal plate 4 in the short-side direction 3. When the metal plate 4 expands, the tensile stress in the long-side direction 2 is larger than the tensile stress in the short-side direction 3. In this case, the ceramic substrate 1 has a larger compressive stress in the long-side direction 2 than in the short-side direction 3.

In the example shown in FIG. 4B, the length of the metal plate 4 in the short-side direction 3 is longer than the length of the metal plate 4 in the long-side direction 2. When the metal plate 4 expands, the tensile stress in the short-side direction 3 is larger than the tensile stress in the long-side direction 2. In this case, the ceramic substrate 1 has a larger compressive stress in the short-side direction 3 than in the long-side direction 2.

In the examples shown in FIGS. 4A and 4B, the bonding layer 6 includes a protruding portion. The protruding portion is a portion protruding outward from the end portion of the metal plate 4 and does not overlap the metal plate 4 in the thickness direction of the substrate. Although the protruding portion can be omitted, when the bonding layer 6 includes the protruding portion, the TCT characteristics can be further improved.

A method for manufacturing the ceramic substrate 1 according to the embodiment will be described. The method for manufacturing the ceramic substrate according to the embodiment is not limited as long as the ceramic substrate has the above-described configuration. Here, a method for obtaining the ceramic substrate 1 with a high yield will be described.

First, a ceramic substrate is prepared. The ceramic substrate may be produced by an existing technique, or a commercially available ceramic substrate may be used. A process of applying compressive stress to the surface of the ceramic substrate is performed. The compressive stress is applied by processing treatment or heat treatment. The processing treatment is, for example, dry blasting or surface polishing.

The dry blasting is a method of jetting abrasive grains onto the surface of the ceramic substrate to process the surface. In the dry blasting, alumina abrasive grains can be used. For example, the grain size of the abrasive grains is within a range of not less than 10 µm and not more than 0.2 mm, and the jetting pressure of the abrasive grains is within a range of not less than 0.1 MPa and not more than 1 MPa. As the grain size of the abrasive grains increases or the jetting pressure of the abrasive grains increases, the applied compressive stress increases (the negative value increases). As the grain size decreases or the jetting pressure of the abrasive grains decreases, the applied compressive stress decreases (the negative value decreases).

Preparing an angle at which the abrasive grains are made to collide with the surface of the ceramic substrate is effective in controlling the compressive stress. In normal dry blasting, the abrasive grains are made to collide with the surface of the ceramic substrate from the 90° direction (vertical direction). In order to control the compressive stress, it is effective to make the abrasive grains collide with the surface of the ceramic substrate from an oblique direction.

The oblique direction means that the direction in which the abrasive grains are jetted is within a range of not less than 20° and not more than 70° relative to the surface of the ceramic substrate. As the angle of the abrasive grains relative to the surface increases, a portion in which the compressive stress is large (the negative value is large) is more likely to be formed. Making the abrasive grains collide with the ceramic substrate from the oblique direction is herein referred to as making the abrasive grains collide obliquely.

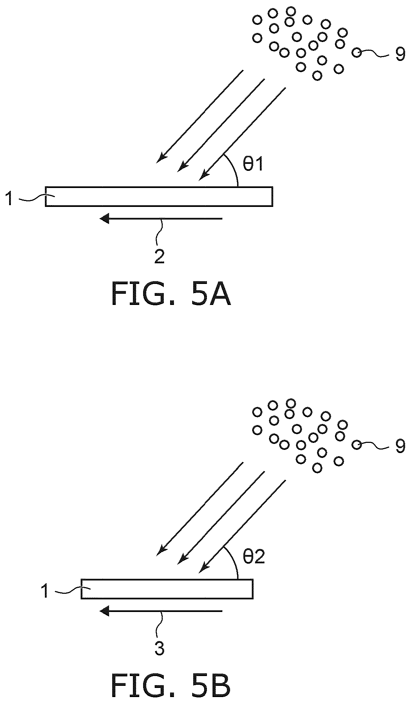

FIG. 5A and FIG. 5B are side views showing example dry blasting. In FIG. 5A and FIG. 5B, reference numeral 1 indicates the ceramic substrate, reference numeral 2 indicates the direction parallel to the long side, reference numeral 3 indicates the direction parallel to the short side, and reference numeral 9 indicates abrasive grains.

FIG. 5A shows a state in which the abrasive grains 9 are made to collide obliquely to the long-side direction 2 of the ceramic substrate 1. In the treatment shown in FIG. 5A, in a plane parallel to the long-side direction 2 and the thickness direction, the angle θ1 between the long-side direction 2 and the direction of the abrasive grains 9 is controlled to not less than 20° and not more than 70°. With this treatment, compressive stress is applied to the surface of the ceramic substrate 1 in the long-side direction 2.

FIG. 5B shows a state in which the abrasive grains 9 are made to collide obliquely to the short-side direction 3 of the ceramic substrate 1. In the treatment shown in FIG. 5B, in a plane parallel to the short-side direction 3 and the thickness direction, the angle θ2 between the short-side direction 3 and the direction of the abrasive grains 9 is controlled to not less than 20° and not more than 70°. With this treatment, compressive stress is applied to the surface of the ceramic substrate 1 in the short-side direction 3.

When the angle θ1 and the angle θ2 are adjusted, the ratio between the compressive stress A and the compressive stress B can be controlled. As described above, an adjustment of the jetting pressure may be combined with an adjustment of the angle. In a case where the jetting direction of the abrasive grains is fixed in application of compressive stress in the long-side direction 2 or the short-side direction 3, it is preferable to perform dry blasting while conveying the ceramic substrate. When the ceramic substrate is made to pass through a region in which the abrasive grains are jetted with the jetting direction being fixed, the abrasive grains can be made to collide obliquely to the ceramic substrate. For example, in a case where the positional relationship between the injection nozzle and the ceramic substrate is fixed and the region in which the abrasive grains are jetted is small relative to the ceramic substrate, it is necessary to make the abrasive grains hit the entire surface of the ceramic substrate while changing the orientation of the injection nozzle. In this case, the jetting direction is not oblique in some time period while the injection nozzle is being moved, or the angle at which the abrasive grains hit the surface of the ceramic substrate varies by location on the surface of the ceramic substrate. Therefore, in order to uniformly apply compressive stress to the entire surface of the ceramic substrate, it is preferable to set the jetting direction of the abrasive grains to a fixed direction and to make the abrasive grains hit obliquely to the ceramic substrate while conveying the ceramic substrate.

Further, one of or both conveyance for applying compressive stress in the long-side direction and conveyance for applying compressive stress in the short-side direction may be performed. In the conveyance process, for example, a belt conveyor can be used. When the conveyance speed is controlled, the angle at which the abrasive grains collide can be controlled.

The surface polishing is a method of surface treatment using a grinding wheel. As the grain size of the grinding wheel used in the surface polishing increases, the applied compressive stress increases. As the grain size of the grinding wheel decreases, the applied compressive stress decreases.

For example, when polishing is performed along the long-side direction 2 of the ceramic substrate 1, compressive stress can be applied in the long-side direction 2. When polishing is performed along the short-side direction 3 of the ceramic substrate 1, compressive stress can be applied in the short-side direction 3. It is also effective to perform both polishing in the long-side direction 2 and polishing in the short-side direction 3. Further, when polishing in the long-side direction 2 and polishing in the short-side direction 3 are alternately performed, the ratio between the compressive stresses can be easily controlled.

The grain size of the abrasive grains used in the dry blasting and that of the grinding wheel used in the surface polishing are specified in JIS-R-6001-1 and JIS-R-6001-2. JIS-R-6001-1 corresponds to ISO 8486-1. JIS-R-6001-2 corresponds to ISO 8486-2.

In a case where compressive stress is applied by heat treatment, pressure during the heat treatment is controlled. For example, the ceramic substrate 1 is manufactured by mixing ceramic powder, which serves as a base material, and sintering aid powder, and molding, debinding, and sintering the mixture. The sintering process is performed within a range of not less than 1500°C and not more than 2000°C. In a case where the pressure in the sintering process is made higher, the compressive stress can be increased. In a case where the pressure in the sintering process is made lower, the compressive stress can be decreased.

It is also effective to perform reheat treatment on the ceramic substrate 1 obtained by the sintering process, while applying pressure. The temperature of the reheat treatment is, for example, within a range of not less than 1000°C and not more than 2000°C. Also in the reheat treatment, in a case where the pressure is made higher, the compressive stress can be increased. In a case where the pressure is made lower, the compressive stress can be decreased.

The pressure in the sintering process or the reheat treatment is preferably 0.3 MPa or more. For example, if the pressure is 0.5 MPa or less, the compressive stress can be decreased. If the pressure exceeds 0.5 MPa, the compressive stress can be increased. The upper limit of the pressure is not specifically limited, but is preferably 2 MPa or less. If the pressure exceeds 2 MPa, the load on the manufacturing equipment may be increased.

Adjusting the cooling rate after the sintering process is also effective in controlling the compressive stress. Increasing the cooling rate can increase the applied compressive stress. Decreasing the cooling rate can decrease the applied compressive stress. Similarly, in the reheat treatment, increasing the cooling rate increases the applied compressive stress. Decreasing the cooling rate decreases the applied compressive stress. For example, if the cooling rate is 120°C/hour or more, the compressive stress can be increased. If the cooling rate is less than 120°C/hour, the compressive stress can be decreased.

As described above, methods for controlling the compressive stress include the blasting, the surface treatment, pressure adjustment in the sintering process, pressure adjustment in the reheat treatment, cooling rate adjustment in the sintering process, and cooling rate adjustment in the reheat treatment. One of these methods may be used or any combination of the methods may be used.

In a case where multi-dicing is performed, these methods may be performed on the large-sized substrate before division or may be performed on the ceramic substrates obtained after the division. At least any of the methods is used to control the compressive stress to within a range of not less than -250 MPa and not more than -60 MPa and to control the ratio A/B.

The blasting, the surface treatment, and the reheat treatment are performed on the ceramic substrate that has been subjected to the sintering process. When any of these treatments is performed after the residual stress of the ceramic substrate is measured, the compressive stress in each direction can be easily controlled. Therefore, when the ceramic substrate 1 according to the embodiment is manufactured, it is preferable to perform at least one type selected from among the blasting, the surface treatment, and the reheat treatment.

In particular, the blasting and the surface treatment are effective in making compressive stresses in the respective directions differ on the surface of the ceramic substrate. Therefore, when the ceramic substrate 1 according to the embodiment is manufactured, it is preferable to perform at least one type selected from among the blasting and the surface treatment.

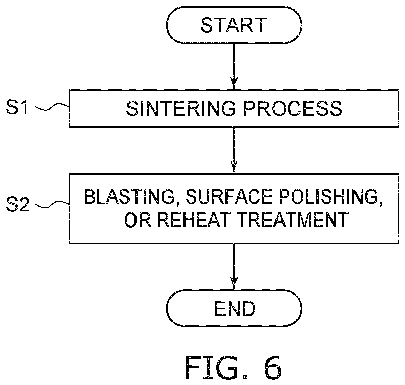

FIG. 6 is a flowchart showing an example method for manufacturing the ceramic substrate according to the embodiment. First, the sintering process is performed to produce a ceramic substrate (step S1). In the sintering process, the pressure may be adjusted to control the residual stress. Next, at least one type selected from among blasting, surface treatment, and reheat treatment is performed on the ceramic substrate (step S2). Before step S2, residual stress on the surface of the ceramic substrate 1 may be measured, and whether to perform step S2 may be determined. Conditions in step S2 may be adjusted in accordance with the residual stress. In a case where a plurality of treatments are performed in step S2, the residual stress may be measured between the treatments. Depending on the residual stress, whether to perform the subsequent treatment may be determined, or conditions for the subsequent treatment may be adjusted.

A circuit portion formed of, for example, a metal plate, a metallized layer, or a thin film is formed on the ceramic substrate 1 to which predetermined compressive stresses have been applied, thereby producing a ceramic circuit board. A circuit shape may be applied to the metal plate, the metallized layer, or the thin film by, for example, an etching process if necessary. A protruding portion may be formed in the bonding layer by the etching process. After the circuit portion is formed, multi-dicing of dividing the ceramic substrate 1 may be performed. When semiconductor elements are mounted on the ceramic circuit board, a semiconductor device can be formed.

### (Examples 1 to 7 and Comparative Examples 1 to 3)

Silicon nitride substrates, an aluminum nitride substrate, and an aluminum oxide substrate were prepared as ceramic substrates. The thermal conductivity of the silicon nitride substrates was 90 W/m·K, and the three-point bending strength thereof was 700 MPa. The thermal conductivity of the aluminum nitride substrate was 170 W/m·K, and the three-point bending strength thereof was 370 MPa. The thermal conductivity of the aluminum oxide substrate was 25 W/m·K, and the three-point bending strength thereof was 400 MPa.

After measuring the compressive stresses of the ceramic substrates, a process for controlling the compressive stresses was performed. Specifically, in order to control the compressive stresses, blasting or surface treatment was performed. In Examples 1, 3, and 4, blasting was performed on the surfaces of the ceramic substrates from an oblique direction (within an angle range of not less than 20° and not more than 70°). In Examples 2 and 5, surface polishing was performed alternately in the long-side direction and the short-side direction. In Example 6, blasting was performed from an oblique direction (within an angle range of not less than 20° and not more than 70°), and thereafter, reheat treatment was performed. In Example 7, surface polishing was performed alternately in the long-side direction and the short-side direction, and thereafter, reheat treatment was performed. Regarding the reheat treatment in Examples 6 and 7, the residual stresses on the surfaces of the ceramic substrates were measured before the heat treatment, and heat treatment conditions were selected based on the measurement results. When the residual stress was low, the reheat treatment was performed at a high pressure or a fast cooling rate. When the residual stress was high, the reheat treatment was performed at a low pressure or a low cooling rate.

In Comparative Example 1, surface treatment was not performed on the ceramic substrate. In Comparative Example 2, blasting was performed from a direction perpendicular to the surface of the ceramic substrate (at an angle of 90°). In Comparative Example 3, polishing was performed only along the long-side direction. Table 1 shows the conditions in Examples and Comparative Examples.

**[Table 1]**

| | Ceramic substrate | | Surface treatment conditions |
|---|---|---|---|
| | Material | Dimensions: Long side × Short side × Thickness (mm) | |
| Example 1 | Si₃N₄ | 140×100×0.32 | Blasting |
| Example 2 | Si₃N₄ | 160×130×0.25 | Surface polishing |
| Example 3 | Si₃N₄ | 180×150×0.32 | Blasting |
| Example 4 | AlN | 120×100×0.635 | Blasting |
| Example 5 | Al₂O₃ | 120×100×0.635 | Surface polishing |
| Example 6 | Si₃N₄ | 120×100×0.25 | Blasting → Reheat treatment |
| Example 7 | Si₃N₄ | 140×120×0.32 | Surface polishing → Reheat treatment |
| Comparative example 1 | Si₃N₄ | 140×100×0.32 | None |
| Comparative example 2 | Si₃N₄ | 140×100×0.32 | Blasting (vertical direction) |
| Comparative example 3 | Si₃N₄ | 140×100×0.32 | Surface polishing (only long-side direction) |

The compressive stresses on the surfaces of the obtained ceramic substrates were measured. The method for measuring the compressive stresses is as described above. The compressive stress in the long-side direction was defined as "compressive stress A", and the compressive stress in the short-side direction was defined as "compressive stress B". The maximum height Sz and the difference between the maximum projection height and the maximum indentation depth of the waviness were measured. The method for measuring each of the heights and the depth is as described above. The results are shown in Table 2.

**[Table 2]**

| | Compressive comparison A (MPa) | Compressive comparison B (MPa) | A/B | B/A | \| Maximum projection height - Maximum indentation depth \| (mm) | **Sz** (µm) |
|---|---|---|---|---|---|---|
| Example 1 | -90 | -120 | 0.75 | 1.33 | 0.2 | 40 |
| Example 2 | -80 | -100 | 0.80 | 1.25 | 0.4 | 30 |
| Example 3 | -180 | -200 | 0.90 | 1.11 | 0.6 | 50 |
| Example 4 | -100 | -70 | 1.43 | 0.70 | 1.2 | 55 |
| Example 5 | -74 | -60 | 1.23 | 0.81 | 1.2 | 60 |
| Example 6 | -230 | -205 | 1.12 | 0.89 | 0.5 | 35 |
| Example 7 | -227 | -245 | 0.92 | 1.08 | 0.7 | 44 |
| Comparative example 1 | -100 | -100 | 1.00 | 1.00 | 1.2 | 74 |
| Comparative example 2 | -40 | -200 | 0.20 | 5.00 | 1.2 | 45 |
| Comparative example 3 | -140 | -50 | 2.80 | 0.36 | 1.2 | 40 |

As can be seen from Table 2, in the ceramic substrates according to Examples, the compressive stress A and the compressive stress B were within a range of not less than -250 MPa and not more than -60 MPa. The compressive stresses A and B were different, and 4/6 ≤ ratio A/B ≤ 6/4 was satisfied. Further, 4/6 ≤ ratio B/A ≤ 6/4 was also satisfied. In the ceramic substrates according to Examples, the difference between the maximum projection height and the maximum indentation depth of the waviness was 1.6 mm or less. The maximum height Sz was 60 µm or less.

In contrast, in Comparative Example 1, the ratio A/B was 1. The ratio A/B = 1 indicates that the ratio A/B is within a range of not less than 0.995 and not more than 1.004. In Comparative Example 2 and Comparative Example 3, one of the compressive stresses A and B was out of the preferable range, and the ratio A/B was out of the preferable range.

Next, the ceramic substrates according to Examples were scribed and divided into a plurality of ceramic substrates. In multi-dicing by the dividing, the large-sized substrate was divided into three equal parts in the long-side direction and two equal parts in the short-side direction to obtain six ceramic substrates.

The compressive stresses, the maximum projection height, the maximum indentation depth, and the maximum height Sz were measured for each of the ceramic substrates obtained after the division. As a result, in Examples, the compressive stress A and the compressive stress B were within a range of not less than -250 MPa and not more than -60 MPa in all of the ceramic substrates. The compressive stresses A and B were different from each other, and 4/6 ≤ ratio A/B ≤ 6/4 was satisfied. The difference between the maximum projection height and the maximum indentation depth of the waviness was 1.6 mm or less. The maximum height Sz was 60 µm or less. It was found from Examples that even if multi-dicing is performed, measurement results similar to those of the large-sized substrates can be obtained.

Next, metal plates were bonded to both faces of the ceramic substrates according to Examples and Comparative Examples. The ceramic substrates obtained after the multi-dicing were used. As the metal plates, copper plates were used. Three types of copper plates having thicknesses of 0.3 mm, 0.6 mm, and 1.0 mm were prepared. As the brazing filler for bonding, an Ag-Cu-Sn-Ti active metal brazing filler was used. Each copper plate was subjected to an etching process to produce ceramic circuit boards. The shape of the copper plates obtained after the etching was a rectangular shape in plan view.

The TCT characteristics of each ceramic circuit board were examined. The silicon nitride circuit boards were subjected to 3000 cycles, one cycle including -30°C for 30 min., room temperature for 10 min., 170°C for 30 min., and room temperature for 10 min. in this order. The aluminum nitride circuit boards and the aluminum oxide circuit boards were subjected to 3000 cycles, one cycle including -30 for 30 min., room temperature for 10 min., 125°C for 30 min., and room temperature for 10 min. in this order. In each of Examples and Comparative Examples, the TCT was performed on 100 ceramic circuit boards.

After the TCT, the presence or absence of cracks in the ceramic substrate or the bonding layer was determined. The presence or absence of cracks was determined by ultrasonic defect inspection (Scanning Acoustic Tomography (SAT)). Examples in which the occurrence of cracking was not less than 0% and not more than 1% were regarded as excellent, examples in which the occurrence of cracking was more than 1% and not more than 3% were regarded as good, and examples in which the occurrence of cracking was more than 3% were regarded as poor. The results are shown in Table 3.

**[Table 3]**

| | TCT characteristics | | |
|---|---|---|---|
| | Copper plate thickness 0.3mm | Copper plate thickness 0.6mm | Copper plate thickness 1.0mm |
| Example 1 | Excellent | Excellent | Excellent |
| Example 2 | Excellent | Excellent | Excellent |
| Example 3 | Excellent | Excellent | Excellent |
| Example 4 | Excellent | Good | Good |
| Example 5 | Excellent | Good | Good |
| Example 6 | Excellent | Excellent | Excellent |
| Example 7 | Excellent | Excellent | Excellent |
| Comparative example 1 | Excellent | Poor | Poor |
| Comparative example 2 | Good | Poor | Poor |
| Comparative example 3 | Good | Poor | Poor |

The TCT characteristics of the silicon nitride circuit boards were excellent even for the thickness of the copper plate increased from 0.3 mm to 0.6 mm and 1.0 mm. In Example 4 (aluminum nitride circuit board) and Example 5 (aluminum oxide circuit board), the TCT characteristics were excellent for the thickness of 0.3 mm. Since the strength of the aluminum nitride substrate and the aluminum oxide substrate was low, the TCT characteristics were degraded in a case of the thickness of 0.6 mm or more.

In contrast, in Comparative Example 1 to 3, many faults occurred in the case of the copper plate thickness of 0.6 mm or more. It was found that when the copper plate was thick and the stress increased, the effect of stress reduction became insufficient and faults occurred. Therefore, it can be said that Examples are suitable for ceramic circuit boards in which a copper plate having a thickness of 0.6 mm or more is used.

Embodiments of the invention include the following features.

### (Feature 1)

A ceramic substrate including a surface, and having a compressive stress in a first direction and a compressive stress in a second direction, the compressive stress in the first direction and the compressive stress in the second direction having different values, the first direction and the second direction being parallel to the surface and orthogonal to each other,
the ceramic substrate satisfying 4/6 ≤ compressive stress A/compressive stress B ≤ 6/4 where the compressive stress A denotes the compressive stress in the first direction and the compressive stress B denotes the compressive stress in the second direction.

### (Feature 2)

The ceramic substrate according to Feature 1, in which the compressive stress A and the compressive stress B are within a range of not less than -250 MPa and not more than -60 MPa.

### (Feature 3)

The ceramic substrate according to Feature 1 or 2, in which a maximum height Sz of the surface is 60 µm or less.

### (Feature 4)

The ceramic substrate according to any one of Features 1 to 3, in which a difference between a maximum projection height and a maximum indentation depth of waviness of the surface is 1.6 mm or less.

### (Feature 5)

The ceramic substrate according to any one of Features 1 to 4, in which
the surface has a quadrangular shape,
the first direction is parallel to one side, and
the second direction is parallel to another side.

### (Feature 6)

The ceramic substrate according to Feature 5, in which a length of a long side is 100 mm or more.

### (Feature 7)

The ceramic substrate according to any one of Features 1 to 6, in which the ceramic substrate is a silicon nitride substrate.

### (Feature 8)

The ceramic substrate according to any one of Features 1 to 7, in which a thickness of the ceramic substrate is within a range of not less than 0.2 mm and not more than 1 mm.

### (Feature 9)

A ceramic circuit board including:
the ceramic substrate according to any one of Features 1 to 8; and
a circuit portion provided on the surface.

### (Feature 10)

The ceramic circuit board according to Feature 9, in which the circuit portion is a metal plate having a thickness of 0.6 mm or more.

### (Feature 11)

The ceramic circuit board according to Feature 9, in which
the circuit portion is a metal plate having a thickness of 0.6 mm or more,
a length of the metal plate in the second direction is longer than a length of the metal plate in the first direction, and
the compressive stress B is larger than the compressive stress A.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention. Moreover, above-mentioned embodiments can be combined mutually and can be carried out.

### [Reference Numeral List]

1 ceramic substrate
2 direction parallel to long side
3 direction parallel to short side
4 metal plate (front metal plate)
5 metal plate (back metal plate)
6 bonding layer
7 first measurement point
8 second measurement point
9 abrasive grains
10 ceramic circuit board

## Claims

1. A ceramic substrate comprising a surface, and having a compressive stress in a first direction and a compressive stress in a second direction, the compressive stress in the first direction and the compressive stress in the second direction having different values, the first direction and the second direction being parallel to the surface and orthogonal to each other,
the ceramic substrate satisfying 4/6 ≤ compressive stress A/compressive stress B ≤ 6/4 where the compressive stress A denotes the compressive stress in the first direction and the compressive stress B denotes the compressive stress in the second direction.

2. The ceramic substrate according to claim 1, wherein the compressive stress A and the compressive stress B are within a range of not less than -250 MPa and not more than -60 MPa.

3. The ceramic substrate according to claim 1 or 2, wherein a maximum height Sz of the surface is 60 µm or less.

4. The ceramic substrate according to claim 1 or 2, wherein a difference between a maximum projection height and a maximum indentation depth of waviness of the surface is 1.6 mm or less.

5. The ceramic substrate according to claim 3, wherein a difference between a maximum projection height and a maximum indentation depth of waviness of the surface is 1.6 mm or less.

6. The ceramic substrate according to claim 1 or 2, wherein
the surface has a quadrangular shape,
the first direction is parallel to one side, and
the second direction is parallel to another side.

7. The ceramic substrate according to claim 5, wherein
the surface has a quadrangular shape,
the first direction is parallel to one side, and
the second direction is parallel to another side.

8. The ceramic substrate according to claim 6, wherein a length of a long side is 100 mm or more.

9. The ceramic substrate according to claim 7, wherein a length of a long side is 100 mm or more.

10. The ceramic substrate according to claim 1 or 2, wherein the ceramic substrate is a silicon nitride substrate.

11. The ceramic substrate according to claim 7, wherein the ceramic substrate is a silicon nitride substrate.

12. The ceramic substrate according to claim 9, wherein the ceramic substrate is a silicon nitride substrate.

13. The ceramic substrate according to claim 1 or 2, wherein a thickness of the ceramic substrate is within a range of not less than 0.2 mm and not more than 1 mm.

14. The ceramic substrate according to claim 7, wherein a thickness of the ceramic substrate is within a range of not less than 0.2 mm and not more than 1 mm.

15. The ceramic substrate according to claim 11, wherein a thickness of the ceramic substrate is within a range of not less than 0.2 mm and not more than 1 mm.

16. A ceramic circuit board comprising:
the ceramic substrate according to claim 1; and
a circuit portion provided on the surface.

17. A ceramic circuit board comprising:
the ceramic substrate according to claim 7; and
a circuit portion provided on the surface.

18. A ceramic circuit board comprising:
the ceramic substrate according to claim 1; and
a circuit portion provided on the surface.

19. The ceramic circuit board according to claim 17, wherein the circuit portion is a metal plate having a thickness of 0.6 mm or more.

20. The ceramic circuit board according to claim 18, wherein
the circuit portion is a metal plate having a thickness of 0.6 mm or more,
a length of the metal plate in the second direction is longer than a length of the metal plate in the first direction, and
the compressive stress B is larger than the compressive stress A.
